# EUROPEAN PATENT APPLICATION

(11) **EP 0 660 449 A2**
(43) Date of publication of application: **28.06.1995**
(21) Application number: 94119539.8
(22) Date of filing: 09.12.1994
(51) Int. Cl.: H01R 13/52, H01R 43/18

(54) **Electrical feedthrough and its manufacture, and apparatus utilizing the feedthrough**

(30) Priority: 09.12.1993 US 165770
(71) Applicant: Santa Barbara Research Center, Goleta California 93117 (US)
(72) Inventor: Eneim, Arthur A., Goleta, CA 93117 (US); Romano, Timothy A., Goleta, CA 93117 (US); Hughes,Gary B., Goleta, California 93117 (US)
(74) Representative: KUHNEN, WACKER & PARTNER

(57) **Abstract**

An electrical feedthrough is formed of a first layer of an electrically insulating material, an electrically conductive trace overlying the first layer, and a second layer of an electrically insulating material overlying the first layer and the electrically conductive trace, such that the electrically conductive trace is sandwiched between the first layer and the second layer. The insulating materials are preferably ceramics that are co-fired with the electrically conductive trace during the manufacture of the feedthrough. The feedthrough is utilized by joining it to an aperture through the wall of an apparatus. In one form, the feedthrough itself is hermetic and can be joined to the wall with a hermetic seal.

## Description

### BACKGROUND OF THE INVENTION

This invention relates to electrical feedthroughs and, more particularly, to a hermetic ceramic electrical feedthrough.

Many types of apparatus utilize an electrical feedthrough across a wall that otherwise separates two environments. The electrical feedthrough permits electrical signals to be conducted across the wall, but prevents any movement of mass across the wall. As an example, an infrared sensor is typically contained in a vacuum enclosure. The sensor is cooled to cryogenic temperatures, typically about 77K or less. Output signals are conducted from the sensor to electronic devices located exterior to the vacuum enclosure, without losing the hermetic vacuum seal, via an electrical feedthrough in the wall of the enclosure.

The feedthrough is usually constructed with a plurality of electrical conductors supported in an insulating material such as a ceramic or a polymer. The insulating material is joined to and contacts the remainder of the wall of the vacuum enclosure. The insulating material isolates the electrical conductors from the wall and from each other.

In existing designs, the feedthrough constitutes a structural element of the wall of the enclosure. That is, the feedthrough is a necessary component to carry a portion of the structural loadings. In one design, for example, the feedthrough is in the form of a relatively large ring to which upper and lower portions of the vacuum enclosure are attached.

The utilization of the feedthrough as a structural element of the wall of the vacuum enclosure has significant drawbacks, particularly where the insulating portion of the feedthrough is a ceramic. Most ceramics have low ductilities and are therefore not well suited for use under the structural loadings that may be experienced in some portions of the wall. The structural ceramic feedthrough, where employed, is often a weak link in the construction of the vacuum enclosure.

The use of a ceramic in a feedthrough that is a structural element is complicated by the fact that the enclosure is cooled to some extent at the same time the sensor is cooled. Ceramics typically have much smaller coefficients of thermal expansion than metals, so that thermal stresses and strains are created in the ceramic as the apparatus is used in service. Where the structural ceramic feedthrough is relatively large in size, these stresses and strains may be of sufficient magnitude that they can lead to structural failure. The ceramic or its joint to the remainder of the vacuum enclosure may also fail to the extent that a leakage develops across the wall. Such a failure need not be a gross structural failure. The loss of the hermetic seal itself represents a failure of the entire apparatus.

Because of such problems, devices using ceramic feedthroughs are limited as to their designs and choices of ceramic materials. They also tend to be less robust and reliable than they might otherwise be. This is a widespread, commercially important problem because of the number of applications requiring electrical feedthroughs across a hermetic sealing wall.

There is therefore a need for an improved electrical feedthrough design that overcomes these problems. The present invention fulfills this need, and further provides related advantages.

### SUMMARY OF THE INVENTION

The present invention provides an electrical feedthrough that may be used in a hermetically sealed apparatus such as a vacuum enclosure. The electrical feedthrough is not a structural component of the apparatus, and therefore is far less susceptible to failure due to mechanical loadings than are conventional structural electrical feedthroughs. The feedthrough of the invention is relatively small in size, so that thermal stresses and strains developed during heating and cooling are relatively small. The small size and design flexibility of the electrical feedthrough afford more latitude in apparatus design than previously available. The electrical feedthrough and its associated apparatus are more robust and reliable than are conventional feedthroughs and their related apparatus. The small size and the method of manufacture of the electrical feedthrough allow it to be prepared at low cost and high device yields.

In accordance with the invention, an electrical feedthrough comprises a first layer of an electrically insulating material, at least one electrically conductive trace overlying the first layer and extending along a feedthrough length direction, and a second layer of an electrically insulating material overlying the first layer and the at least one electrically conductive trace, such that the at least one electrically conductive trace is sandwiched between the first layer and the second layer.

This electrical feedthrough can be made quite small, by using a fabrication technique wherein the electrically conductive traces are screen painted onto the first layer. The small size permits the traces to be narrow and thin, and closely spaced, for those cases where the currents to be conducted are small. Many traces can be placed into a small feedthrough area. The second layer is placed over the first layer and traces. The assembly is heated to consolidate the traces and, where the insulating material is a ceramic, to fire and consolidate the ceramic.

Achieving a small size in the feedthrough is important for several reasons. It minimizes the accumulation of thermal stresses and strains, which depend upon differences in thermal expansion and also absolute dimensions over which the stresses and strains can build up. The small size also allows more design flexibility by widening the choices of possible feedthrough locations.

An apparatus utilizing such a feedthrough comprises a wall having a feedthrough aperture herein, an electrically interconnected device on a first side of the wall, and an electrical feedthrough extending through the aperture between the first side and a second side of the wall and joined to the wall. The electrical feedthrough comprises a first layer of an electrically insulating material, at least one electrically conductive trace overlying the first layer and extending along a feedthrough length direction from the first side of the wall to the second side of the wall, and a second layer of an electrically insulating material overlying the first layer and the at least one electrically conductive trace, such that the at least one electrically conductive trace is sandwiched between the first layer and the second layer.

In one form, the apparatus has a wall that is continuous and forms an enclosed volume, with the electrically interconnected device contained within that volume. An infrared sensor contained within an evacuated vacuum enclosure is an example of such a construction. The feedthrough is preferably made using ceramic insulation layers. The electrical feedthrough may be joined to the wall using any appropriate technique, with active brazing preferred. The result is a hermetically sealed feedthrough.

The construction of an apparatus using the present approach is distinct from prior apparatus in which the feedthrough forms an integral part of the wall structure. In the present approach, the apparatus is built with a wall having a suitable aperture. The feedthrough is constructed separately in the manner described, placed through the aperture, and actively brazed or otherwise joined to the apparatus wall. The electrical feedthrough is not an integral part of the wall in the sense that it must carry a portion of the structural loadings, although it may incidentally support some small load when joined to the wall. Since the wall is typically a metal and the feedthrough typically a ceramic, upon cooling the feedthrough is placed into compression, which is the preferred stress state for ceramic materials. The structure is far less likely to fail either by loss of hermeticity or gross structural failure than prior feedthroughs.

Other features and advantages of the present invention will be apparent from the following more detailed description of the preferred embodiment, taken in conjunction with the accompanying drawings, which illustrate, by way of example, the principles of the invention.

### BRIEF DESCRIPTION OF THE DRAWINGS

Figure 1 is a schematic sectional view of a sensor apparatus utilizing the present approach;
Figure 2 is a process flow diagram for the preparation of the apparatus of Figure 1;
Figure 3 is a plan view of a first embodiment of the electrical feedthrough;
Figure 4 is a front elevational view of the first embodiment of Figure 3;
Figure 5 is a plan view of a second embodiment of the electrical feedthrough;
Figure 6 is a front elevational view of the second embodiment of Figure 5;
Figure 7 Is an end elevational view of the second embodiment of Figure 5 from a first end;
Figure 8 is an end elevational view of the second embodiment of Figure 5 from a second end; and
Figure 9 is a front elevational view of a third embodiment of the electrical feedthrough, assembled to a wall.

### DETAILED DESCRIPTION OF THE INVENTION

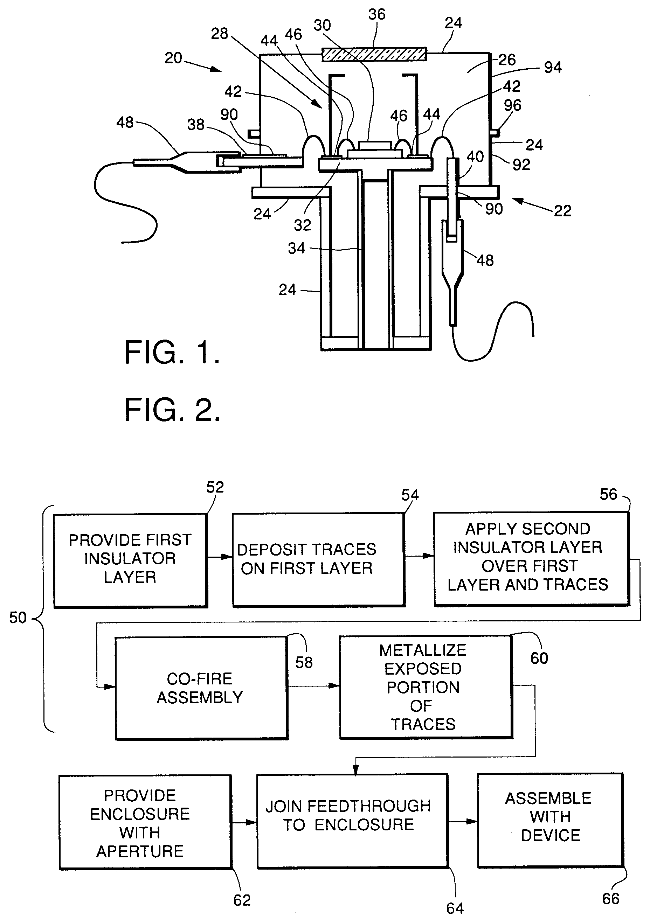

Figure 1 depicts an apparatus 20 having a vacuum enclosure 22 with a wall 24. The wall 24 defines a contained volume 26. The wall 24 is preferably formed by joining a lower housing 92 and an upper housing 94 at a flange 86, so that the upper housing can be removed for access to the contained volume 26. Within the volume is a device 28, in this case a sensor 30, that requires an electrical interconnection with electronic circuitry (not shown) external to the apparatus 20. The sensor 30 is mounted on a base 32, which in turn is mounted on a pedestal 34 that is attached to the interior of the lower housing 92. The pedestal 34 and thence the sensor 30 are cooled by a Joule-Thomson cryostat or other cooling means (not shown) to a temperature that is typically about 77K or less. The sensor 30 faces forwardly through a window 36 which is supported in the upper housing 94.

In the assembled and operating form of the apparatus 20, the contained volume 26 is evacuated. The wall 24 therefore separates an evacuated space from ambient air. An hermetic seal must be maintained between the contained volume 26 inside the vacuum enclosure 22 and the exterior.

The apparatus 20 includes two electrical feedthroughs 38 and 40. The first feedthrough 38 is oriented transversely to the line of sight of the sensor 30, and the second feedthrough 40 is oriented parallel to the line of sight of the sensor. In many instances, a single feedthrough is sufficient, but two are shown here to illustrate two feedthrough configurations and to illustrate the versatility of feedthrough placement made possible by the present approach. Each feedthrough has an fine-wire internal lead 42 from the feedthrough to a conductor 44 on the surface of the base 32, and thence to another lead 46 that connects to the sensor 30. Each feedthrough also has an external electrical connector 48, here shown to be a plug-in connector but which could be a permanent connector or any other suitable type.

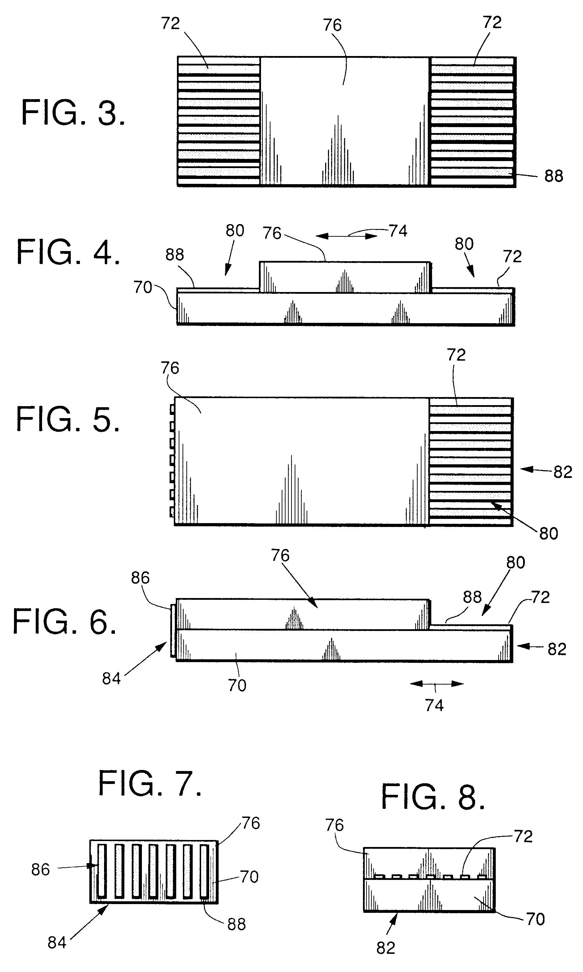

Figure 2 depicts the approach for manufacturing such an apparatus 20. Figures 3 and 4 depict the feedthrough 38 in more detail. Figures 5-8 depict the feedtbrough 40 in more detail.

To manufacture the apparatus 20, the feedthrough 38 or 40 is first prepared, numeral 50. The several steps of the preparation are shown in more detail. A first insulator layer 70 is provided, numeral 52. The insulator layer 70 may be any insulator material, but is preferably a ceramic such as aluminum oxide or aluminum nitride. Unfired ceramic insulator material mixed with an organic binder such as an acrylic is available commercially in the form of thin sheets or strips about 0.01-0.08 inches thick. A piece of the desired size is cut from this sheet or strip.

At least one, and preferably a plurality of, traces 72 are deposited upon one side of the first insulator layer 70, numeral 54. The traces 72 are preferably deposited by silk screen printing, a well-established technique for depositing thin layers onto a substrate. A slurry containing metallic particles in a liquid carrier is silk screened onto the first insulator layer 70 with a screen of the desired trace pattern. This pattern is typically, but not necessarily, a number of parallel traces extending parallel to a length direction 74 of the feedthrough. The metallic particles may be any conductive material, but are preferably an alloy containing molybdenum and manganese or tungsten. The liquid carrier is typically an acrylic liquid. The particle loading is such that the slurry may be readily painted over the silk screen.

A second insulator layer 76 is applied over the first insulator layer 70 and the traces 72 on its surface, so that the traces 72 are sandwiched between the layers 76 and 70. The second insulator layer 76 is preferably somewhat shorter In its dimension parallel to the length direction 74 than is the first insulator layer 70. As shown in Figures 3 and 4 for the feedthrough 38, the second insulator layer 76 may be placed intermediate the ends of the first layer 70 so that there is an upwardly exposed area 80 of the traces 72 at each end of the first insulator layer 70.

As shown in Figures 5-8 for the feedthrough 40, the second insulator layer 76 may instead be placed substantially flush with one end (or both ends, in another embodiment) of the first insulator layer 70. In this version, there is an upwardly exposed area 80 of the traces 72 at one end 82 of the feedthrough 40, but only an exposed end of the traces 72 at the other end 84 of the feedthrough 40. To provide a connection location at this second end 84, a second set of traces 86 is applied to the end 84 in electrical contact with the exposed portion of the traces 72, again preferably by silk screening. The second set of traces 86 is shown most clearly in Figure 7.

The two embodiments 38 and 40 of the feedthrough are thus similar in many respects, but differ in the manner discussed. The two different embodiments are provided so that connections may be made more easily. As shown in Figure 1, it is most convenient for the particular use of the feedthrough 38 that the leads 42 be attached to an upwardly exposed area 80. On the other hand, it is more convenient for the use of the feedthrough 40 that the leads 42 be attached to the end 84 using the second set of traces 86. It is typically most convenient that the external attachment or connection be made to an upwardly exposed area 80 of traces, as shown for both feedthroughs 38 and 40 in Figure 1. However, one or both of the externally facing ends of the feedthrough 38 or 40 could be made with the configuration shown in Figure 7, if desired.

After the assembly of insulative layers 70 and 76 around the traces 72 is prepared, this assembly is co-fired, numeral 58, in the case of using ceramic material in the layers 70 and 76. The firing is accomplished by heating the assembly to an appropriate firing temperature, typically greater than about 1000°C, for an appropriate time, typically about 1 hour. The heating accomplishes two results. The binder of the ceramic in the layers 70 and 76 is driven out, and the ceramic particles sinter together to form a continuous ceramic piece. Second, the carrier liquid of the slurry used to silk screen the traces 72 is vaporized, and the metallic particles sinter together to form the metallic, electrically conductive trace.

The exposed ends of the traces 72 (and traces 86, where present) are metallized with a bonding layer 88, numeral 60. The metallization is preferably nickel over which a layer of gold is applied. The gold layer serves as a good contact material for connection, wire-bonding of leads, or soldering, and also resists oxidation prior to the time that the connections are made. Both metallic layers are preferably applied by a conventional masking and electroplating procedure, which evenly coats the unmasked portions with a thin layer of the bonding layer material.

The feedthrough 38 or 40 manufactured in this manner is an integral unit that can be handled. It is preferably made with dimensions in the plane of the layer 70 as small as possible, consistent with the required number and size of the traces 72. The smaller these dimensions, the lower the accumulated thermal stresses and strains during temperature changes. One important feature of the present feedthrough design is its small size. In a version of this feedthrough having 18 traces built by the inventors and tested, the feedthrough was only 0.395 inches by 0.470 inches by 0.40 inches thick.

Returning to Figure 2, the enclosure 22 is provided, numeral 62. The enclosure 22 has an aperture 90 therethrough at each location where a feedthrough is to be attached. The aperture 90 is preferably made only marginally larger in size than the width and thickness of the feedthrough, so that there is a relatively close fit when the feedthrough is slipped through the aperture. In a reduction to practice of the invention, the aperture dimensions were made from about 0.004 to about 0.010 inch larger than the respective dimensions of the feedthrough, by forming the aperture by electrodischarge machining.

After the feedthrough 38 or 40 is placed into the aperture 90, it is joined to the wall 24 of the enclosure. The joining may be by any approach which holds the feedthrough in place. In making an apparatus such as the sensor apparatus of Figure 1, the joint must be hermetically sealed in addition to providing a mechanical bond. Any operable sealing approach may be used, but in the preferred approach to forming an hermetic seal, the feedthrough 38 or 40 is brazed to the wall 24 with an active braze metal. Active brazing of ceramics to metals in other contexts is well known in the art, see, for example, H. Mizuhara et al., "Joining Ceramic to Metal with Ductile Active Filler Metal," Welding Journal, pages 43-51 (October 1986). During the transient liquid phase portion of the brazing process the active braze alloy wets to both the ceramic and the metal, forming a hermetic seal.

The device 28 is provided and assembled with the enclosure 22 and feedthrough joined thereto, numeral 66. The enclosure is usually provided in two disassembled pieces 92 and 94, with the feedthroughs joined at the appropriate apertures. The device is assembled to the enclosure, and the electrical connections of the sensor 30 to the feedthroughs using the leads 42 is completed, typically by wirebonding. The enclosure pieces 92 and 94 are assembled and joined to complete the process.

An infrared sensor apparatus like that shown in Figure 1 was prepared by the approach discussed above. This apparatus was subjected to a severe thermal excursion from ambient temperature to 77K by immersion In liquid nitrogen. The mechanical, vacuum, and electrical integrity of the apparatus was maintained.

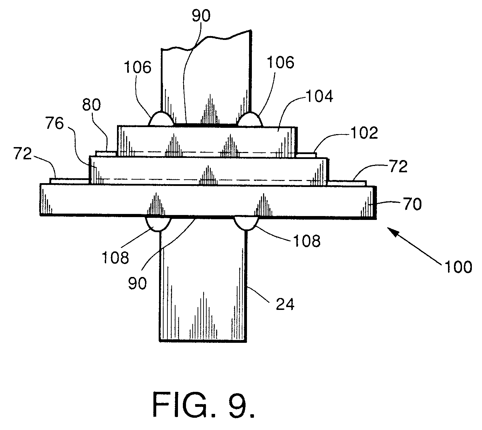

A third embodiment of a feedthrough 100 is shown in Figure 9. The first insulator layer 70, traces 72, and second insulator layer 76 are substantially as shown in the embodiment of Figures 3 and 4. An additional set of traces 102 is deposited onto the opposite side of the second insulator layer 76 from that in contact with the traces 72. A third insulator layer 104 is placed overlying the additional set of traces 102, thereby forming a stack of three insulator layers with sets of traces 72 and 102 therebetween. The embodiment of Figure 9 is pictured with upwardly exposed areas 80 at each end of each set of traces 72 and 102 as in Figures 3 and 4, but the approach of Figure 7 could also be used at any of the ends.

This stacking of traces using intermediate ceramic insulating layers can be continued with more layers and traces. This design is preferably used when there is a large number of traces that must be provided. In that case, one design alternative is to have the ceramic layers 70 and 76 as wide as necessary to accommodate the number of traces that are needed. However, this wide, thin feedthrough configuration is more susceptible to thermally induced stresses and strains than is a configuration that is more nearly square in cross section. The wide, thin feedthrough may be necessary in some designs, however. A virtue of the present approach is that it permits a wide range of feedthrough design configurations.

Figure 9 also illustrates the preferred practice for the joining of the feedthrough 100 (or the feedthroughs 38 or 40) to the wall 24. The aperture 90 is countersunk at each end, numeral 106. The brazing is accomplished to leave a thin film of braze metal in the clearance between the aperture wall and the feedthrough, and to leave a fillet 108 of braze metal at each end in the countersink 106. The fillet 108 ensures a good seal of the feedthrough to the wall and minimizes stress concentrations in the ceramic of the feedthrough.

Although a particular embodiment of the invention has been described in detail for purposes of illustration, various modifications may be made without departing from the spirit and scope of the invention. Accordingly, the invention is not to be limited except as by the appended claims.

## Claims

1. An electrical feedthrough, comprising
a first layer of an electrically insulating material;
at least one electrically conductive trace overlying the first layer and extending along a feedthrough length direction; and
a second layer of an electrically insulating material overlying the first layer and the at least one electrically conductive trace, such that the at least one electrically conductive trace is sandwiched between the first layer and the second layer.

2. The feedthrough of claim 1, wherein at least one of the first layer of an insulating material and the second layer of an insulating material is selected from the group consisting of aluminum oxide and aluminum nitride.

3. The feedthrough of claim 1, wherein the second layer of insulating material is shorter in length than the first layer of insulating material along the feedthrough length direction such that a portion of the at least one electrically conducting trace is exposed to view.

4. The feedthrough of claim 1, further including an attachment layer of a metal over at least a portion of the length of the electrically conductive trace.

5. The feedthrough of claim 1, wherein the at least one electrically conductive trace comprises a plurality of electrically conductive trace.

6. The feedthrough of claim 1, wherein the electrical feedthrough further comprises:
at least one additional electrically conductive trace overlying the second layer on the side remote from the at least one electrically conductive trace and extending along the feedthrough length direction, and
a third layer of an electrically insulating material overlying the second layer and the at least one additional electrically conductive trace, such that the at least one additional electrically conductive trace, such that the at least one additional electrically conductive trace is sandwiched between the second layer and the third layer.

7. A method of preparing an apparatus having an electrical feedthrough, comprising the steps of:
providing a wall having a feedthrough aperture therein;
providing an electrically interconnected device on a first side of the wall;
preparing an electrical feedthrough by the steps of
furnishing a first layer of an electrically insulating material,
depositing at least one electrically conductive trace overlying the first layer and extending along a feedthrough length direction from the first side of the wall to the second side of the wall, and
bonding a second layer of an electrically insulating material overlying the first layer and the at least one electrically conductive trace, such that the at least one electrically conductive trace is sandwiched between the first layer and the second layer; and
joining an electrical feedthrough to the wall with the electrical feedthrough extending through the aperture between the first side and a second side of the wall.

8. The method of claim 7, wherein the step of preparing an electrical feedthrough includes the additional step, after the step of bonding, of
heating the assembly of first layer, at least one electrically conductive trace, and second layer.

9. The method of claim 7, wherein the step of preparing an electrical feedthrough includes the additional step, after the step of bonding, of
depositing an attachment layer of a metal upon an exposed portion of the at least one electrically conductive trace.

10. The method of claim 7, wherein the step of joining includes the step of
active brazing the electrical feedthrough to the wall.
